# EUROPÄISCHE PATENTANMELDUNG

(11) **EP 0 613 339 A1**
(43) Veröffentlichungstag der Anmeldung: **31.08.1994**
(21) Anmeldenummer: 93102937.5
(22) Anmeldetag: 25.02.1993
(51) Int. Cl.: H05K 13/04

(54) **Verfahren, Vorrichtung und Verbindungsstreifen zum Spleissen von Gurten mit Deckbandern**

(71) Anmelder: Willi, A., Dipl.-Ing., Patentanwalt, FL-9490 Vaduz (LI)
(72) Erfinder: Scheidegger, Hans R., CH-4852 Rothrist (CH)

(57) **Zusammenfassung**

Die Vorrichtung (1) nimmt den Verbindungsstreifen (4), sowie Gurtanfang (6) und Gurtende (7) in den Stiften (5) auf. Der Niederhalter (3) fixiert die Gurtenden gegen das herausfallen. Mit dem Presshebel (2) wird der Verbindungsstreifen (4) gefaltet und auf die Oberseite der Gurtenden gepresst, so dass diese nun unten und oben verbunden sind.

Die Verbindung des Deckbandes auf der Gurte kann mit dem Rest des Verbindungsstreifens bewerkstelligt werden. Die noch vorstehenden Reststücke des Verbindungsstreifens müssen nach Entnahme der Gurte aus der geöffneten Vorrichtung weggeschnitten werden.

Mit diesem Verfahren, Vorrichtungen und Verbindungsstreifen entsteht eine Gurtenverbindung und eine Deckbandverbindung, die unabhängig der Gurten-Dimensionen, Breite, Tiefe und Materialdicke, den Belastungen standhält und zu einer grossen Reduktion der Stillstandzeit bei automatischer Bestückung von elektronischen Bauteilen führt.

## Beschreibung

Die Erfindung betrifft ein Verfahren, Vorrichtungen und Verbindungsstreifen zur Herstellung von Gurt-Verbindungen, insbesondere bei planaren Elektronik-Bauteilen in der SMD Technik (Surface monted device).

Die SMD Bauteile werden meist in Vertiefungen oder Ausdehnungen von Gurten aufbewahrt, zugeführt und verarbeitet. Die Gurten werden auf Spulen aufgerollt und besitzen meist eine Perforierung, um den Teilevorschub sicherzustellen. Die Bauteile Anzahl auf einer Gurten-Rolle variieren zwischen 100 - 4000 Stück, je nach Bauteil- und Spulengrösse. Erfolgt die Entnahme der Bauteile aus den Gurten automatisch in unterschiedlichen Mengen pro Typ, so werden in unterschiedlichen Zeitabständen die Rollen leer. Bis die neue Rolle betriebsbereit eingespannt ist vergeht Zeit, und die teuren Automaten stehen still.

Da die Losgrösse einer Produktionsserie und die Bauteile-Anzahl auf einer Rolle nie übereinstimmen, entstehen angebrochene Spulen im Lager mit mehr oder weniger langen Gurten-Resten. Dies führt beim Aufbrauchen der Reste zu zusätzlichen Fertigungsunterbrüchen. Dasselbe Problem tritt auch auf bei gerissenen verzogenen Gurten.

Die vorliegende Erfindung löst diese erwähnten Probleme, indem Anfang und Ende, unabhängig der Gurten-Breite, der Gurten-Tiefe und der Bauteile Position zur Perforierung rasch, ohne Produktionsunterbruch, verbunden werden können.

Verfahren, Vorrichtungen und Verbindungsstreifen gemäss der Erfindung weisen jene Merkmale auf, welche im kennzeichnenden Teil der Patentansprüche beschrieben sind.

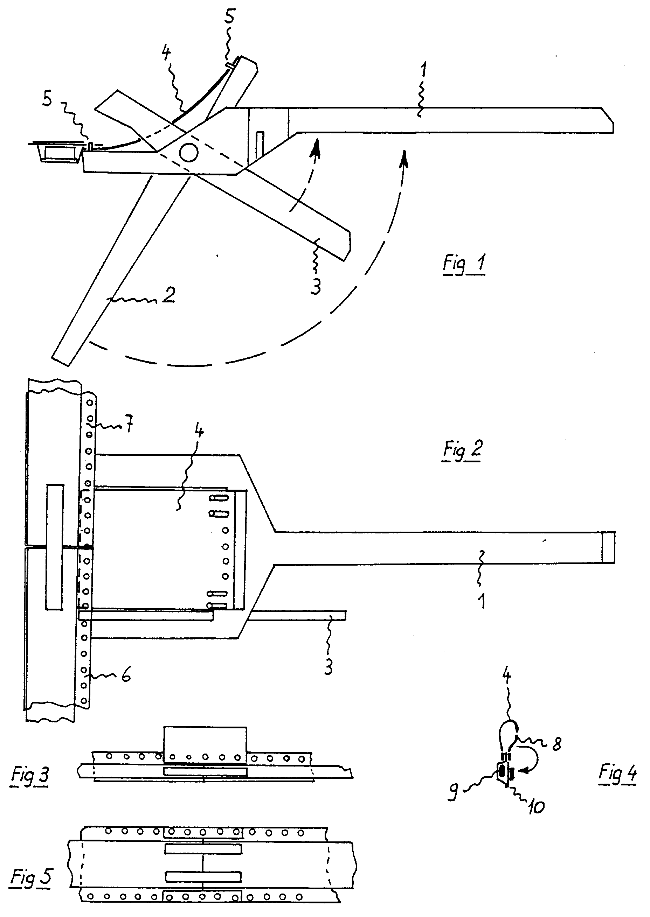

Nachfolgend werden die Erfindungen anhand der Zeichnungen näher erläutert.
- Fig 1: Die Vorrichtung geöffnet im Seitenriss
- Fig 2: Die Vorrichtung geöffnet in Draufsicht
- Fig 3: Schmale perforierte Gurte mit Bauelement und Deckband
- Fig 4: Schnittbild durch Gurte gemäss Fig 3
- Fig 5: Beidseitig perforierte Gurte mit weggeschnittenen Reststücke der Verbindungsstreifen
Das Spleissen eines neuen Gurtes oder eines Rest-Gurtes an einen Gurt mit gleichen Bauteilen (9) Fig 4 wird vorgenommen, indem ein Verbindungsstreifen (4) Fig 1 und 2 in die geöffnete Vorrichtung (1) Fig 1 eingelegt und von den Stiften (5) Fig 1 oben und unten zentriert wird. Das Gurtende (6) Fig 2 wird bis zur Mitte des Verbindungsstreifen (4) in die Stifte (5) der Vorrichtung (1) eingelegt und mit Niederhalter (3) Fig 1 und 2 festgeklemmt. Mit dem Gurtanfang (7) Fig 2 wird gleich vorgegangen, so dass Gurtanfang und Gurtende stumpf aneinanderliegen und die Vorrichtung (1) mit Presshebel (2) geschlossen werden kann. Dadurch wird der Verbindungsstreifen (4) gefalzt und auf die Oberseite der Gurtenden gepresst und verbindet diese.

Die Verbindung des Gurtdeckbandes (10) Fig 4 wird jetzt mit einem oder mehreren Rest-Verbindungsstreifen (8) oder mit einem konventionellen separaten Klebstreifen vorgenommen.

Die Vorrichtung (1) Fig 1 kann nun geöffnet werden, durch Presshebel (2) und Niederhalter (3). Die gespleisste Gurte mit dem gespleissten Deckband wird aus den Stiften (5) gehoben, die restliche vorstehende Schlaufe des Verbindungsstreifens (4) wird weggeschnitten, so dass dem Bestückungsautomat nun eine Endlosgurte zur Verfügung steht.

Bei zweifach perforierten Gurten Fig 5 bleibt der Ablauf gleich, es wird die zweite Seite der Gurte durch Drehen in die Vorrichtung genommen und wie die erste verbunden.

## Patentansprüche

1. Verfahren zum Spleissen von Gurten, insbesondere SMD Blister- und Papiergurten mit Elektronikbauteilen, dadurch gekennzeichnet, dass die Gurtenden (6, 7) mit Hilfe einer Vorrichtung positioniert, Gurtanfang und -Ende gradlinig gehalten und mit mindestens einem Verbindungsstreifen (4) zusammengehalten werden.

2. Verfahren nach Anspruch 1, dadurch gekennzeichnet, dass der Verbindungsstreifen (4) durch Falten den Gurt unten und oben gleichzeitig verbindet.

3. Verfahren nach Anspruch 1, dadurch gekennzeichnet, dass vom Verbindungsstreifen (4) ein Teil (8) als Verbinder des Gurtdeckbandes (10) verwendet wird.

4. Vorrichtung zur Ausführung des Verfahrens nach Anspruch 1, dadurch gekennzeichnet, dass Stifte (5), zur Aufnahme des Verbindungsstreifens (4) und der Gurtenden (6, 7), eine gradlinige Verbindung gewährleisten.

5. Vorrichtung zur Ausführung des Verfahrens nach Anspruch 2, dadurch gekennzeichnet, dass ein Presshebel (2) den Verbindungsstreifen (4) faltet.

6. Vorrichtung nach Anspruch 4, dadurch gekennzeichnet, dass zum Anpressen des Verbindungsstreifens (4) ein Presshebel (2) aufgebaut ist.

7. Vorrichtung nach Anspruch 4 und 6, dadurch gekennzeichnet, dass zum Halten der Gurtenden (6, 7) mindestens ein Niederhalter (3) vorhanden ist.

8. Verbindungsstreifen zur Ausführung des Verfahrens nach Ansprüchen 1 bis 3, dadurch gekennzeichnet, dass er selbstklebend ist und mit einer Perforation, die der Gurtenperforation entspricht, versehen ist.
